# EUROPEAN PATENT APPLICATION

(11) **EP 4 324 878 A1**
(43) Date of publication of application: **21.02.2024**
(21) Application number: 22899077.6
(22) Date of filing: 25.11.2022
(51) Int. Cl.: C08L 23/08, C08L 71/02, H01L 31/048

(54) **COMPOSITION FOR ENCAPSULANT FILM AND ENCAPSULANT FILM COMPRISING SAME**

(30) Priority: 26.11.2021 KR 20210165772
(71) Applicant: LG Chem, Ltd., Seoul 07336 (KR)
(72) Inventor: LEE, Young Woo, Daejeon 34122 (KR); GONG, Jin Sam, Daejeon 34122 (KR); KIM, Jong Gil, Daejeon 34122 (KR); HONG, Sang Hyun, Daejeon 34122 (KR); HAN, Sang Wook, Daejeon 34122 (KR); LEE, Eun Jung, Daejeon 34122 (KR)
(74) Representative: Hoffmann Eitle
(86) International application number: PCT/KR2022/018793
(87) International publication number: WO 2023/096395

(57) **Abstract**

The present invention relates to a composition for an encapsulant film, comprising an ethylene/alpha-olefin copolymer, an encapsulant film and a solar cell module.

## Description

### TECHNICAL FIELD

### Cross-reference to Related Applications

This application claims the benefit of Korean Patent Application No. 2021-0165772, filed on November 26, 2021, in the Korean Intellectual Property Office, the contents of which are incorporated herein by reference.

### Technical Field

The present invention relates to a composition for an encapsulant film, comprising an ethylene/alpha-olefin copolymer, an encapsulant film and a solar cell module.

### BACKGROUND ART

As global environmental problems, energy problems, etc. get worse and worse, solar cells receive attention as an energy generating means without fear of environmental contamination and exhaustion. If solar cells are used outside such as the roof of a building, generally, a module type of the solar cells is used. In order to obtain a crystalline solar cell module when manufacturing a solar cell module, front glass/solar cell encapsulant/crystalline solar cell device/solar cell encapsulant/rear glass (or rear protection sheet) are stacked in order. As the encapsulant of the solar cells, generally, an ethylene/vinyl acetate copolymer or ethylene/alpha-olefin copolymer having excellent transparency, flexibility, adhesiveness, etc. is used.

A solar cell module is obtained by protecting a solar cell device such as silicon, gallium-arsenic, and copper-indium-selenium using an upper transparent protecting material and a lower substrate protecting material, and packaging by fixing the solar cell device and the protecting materials using a sealant. Generally, the sealant of the solar cell device in a solar cell module is formed by extrusion molding of an ethylene/alpha-olefin copolymer mixed with an organic peroxide or a silane coupling agent into a sheet type, and the solar cell device is sealed by using the sheet type sealant to manufacture a solar cell module.

In case of manufacturing the above-described solar cell module, the increase of the affinity of an ethylene/alpha-olefin copolymer with various materials included in a composition for an encapsulant film to improve absorbency may be a way of increasing productivity. Particularly, a crosslinking agent, a crosslinking auxiliary agent, or the like, essentially required to use for the manufacture of an encapsulant film, reduce the volume resistance of the encapsulant film and are pointed to as one of the factors inducing the deterioration of physical properties.

### [Prior Art Document]

### [Patent Document]

(Patent Document 1) Japanese Laid-open Patent No. 2015-211189

### DISCLOSURE OF THE INVENTION

### TECHNICAL PROBLEM

An object of the present invention is to provide a composition for an encapsulant film, having excellent volume resistance and light transmittance, and an encapsulant film comprising the same.

### TECHNICAL SOLUTION

To solve the above tasks, the present invention provides a composition for an encapsulant film, an encapsulant film, and a solar cell module.
(1) The present invention provides a composition for an encapsulant film, comprising an ethylene/alpha-olefin copolymer and polyethylene glycol, wherein a number average molecular weight of the polyethylene glycol is 1,000 to 50,000 g/mol, and the content of the polyethylene glycol is 0.05 to 0.7 wt% based on a total weight of the ethylene/alpha-olefin copolymer and the polyethylene glycol.
(2) The present invention provides the composition for an encapsulant film according to (1), wherein the number average molecular weight of the polyethylene glycol is 2,000 to 30,000 g/mol.
(3) The present invention provides the composition for an encapsulant film according to (1) or (2), wherein the content of the polyethylene glycol is 0.1 to 0.6 wt% based on the total weight of the ethylene/alpha-olefin copolymer and the polyethylene glycol.
(4) The present invention provides the composition for an encapsulant film according to any one among (1) to (3), further comprising one or more selected from the group consisting of a crosslinking agent, a crosslinking auxiliary agent, a silane coupling agent, an unsaturated silane compound, an amino silane compound, a light stabilizer, a UV absorbent and a thermal stabilizer.
(5) The present invention provides the composition for an encapsulant film according to any one among (1) to (4), wherein an alpha-olefin comprises one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene and 1-eicosene.
(6) The present invention provides the composition for an encapsulant film according to any one among (1) to (5), wherein an alpha-olefin is comprised in greater than 0 to 99 mol% based on the ethylene/alpha olefin copolymer.
(7) The present invention provides an encapsulant film comprising the composition for an encapsulant film according to any one of (1) to (6).
(8) The present invention provides a solar cell module comprising the encapsulant film of (7).

### ADVANTAGEOUS EFFECTS

The composition for an encapsulant film of the present invention shows excellent volume resistance and light transmittance, and may be widely used for various usages in an electrical and electronic industrial field.

### BEST MODE FOR CARRYING OUT THE INVENTION

Hereinafter, the present invention will be described in more detail to assist the understanding of the present invention.

It will be understood that words or terms used in the present disclosure and claims shall not be interpreted as the meaning defined in commonly used dictionaries. It will be further understood that the words or terms should be interpreted as having a meaning that is consistent with their meaning in the context of the relevant art and the technical idea of the invention, based on the principle that an inventor may properly define the meaning of the words or terms to best explain the invention.

### <Composition for encapsulant film>

The composition for an encapsulant film of the present invention is characterized in including an ethylene/alpha-olefin copolymer and polyethylene glycol, wherein the number average molecular weight of the polyethylene glycol is 1,000 to 50,000 g/mol, and the content of the polyethylene glycol is 0.05 to 0.7 wt% based on the total weight of the ethylene/alpha-olefin copolymer and the polyethylene glycol.

The composition for an encapsulant film of the present invention includes an ethylene/alpha-olefin copolymer. The ethylene/alpha-olefin copolymer is prepared by copolymerizing ethylene and an alpha-olefin-based monomer, and in this case, an alpha-olefin which means a moiety derived from an alpha-olefin-based monomer in the copolymer may be an alpha-olefin of 4 to 20 carbon atoms, particularly, propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, etc., and any one among them or mixtures of two or more thereof may be used.

Among them, the alpha-olefin may be 1-butene, 1-hexene or 1-octene, preferably, 1-butene, 1-hexene, or the combinations thereof.

In addition, in the ethylene/alpha-olefin copolymer, the alpha-olefin content may be suitably selected in the range satisfying the physical conditions, particularly, greater than 0 to 99 mol%, or 10 to 50 mol%, without limitation.

In the present invention, a preparation method or an obtaining route of the ethylene/alpha-olefin copolymer is not limited, and suitable ones may be selected and used considering the physical properties and purpose of the composition for an encapsulant film by a person skilled in the art.

The composition for an encapsulant film of the present invention includes polyethylene glycol.

The number average molecular weight of the polyethylene glycol is 1,000 to 50,000 g/mol, particularly, 2,000 g/mol or more, 2,500 g/mol or more, 3,000 g/mol or more, and 30,000 g/mol or less, 20,000 g/mol or less, 15,000 g/mol or less, for example, 2,000 g/mol to 30,000 g/mol.

If the polyethylene glycol is included in the composition for an encapsulant film, polyethylene glycol having high polarity and a nonpolar ethylene/alpha-olefin copolymer are blended, and the movement of charges is inhibited to reduce electrical conductivity and increase volume resistance. On the contrary, if a composition for an encapsulant film, using a highly polar polymer, meets polyethylene glycol, electrical conductivity may rather increase, and volume resistance may be reduced.

Particularly, in order to achieve such effects preferably, the number average molecular weight of the polyethylene glycol is required to be 1,000 to 50,000 g/mol.

If the number average molecular weight of the polyethylene glycol is less than 1,000 g/mol, haze may increase to impair optical properties, and the use as an encapsulant film is inappropriate, and if the number average molecular weight of the polyethylene glycol is greater than 50000 g/mol, the polarity of the composition becomes too high, and it is apprehended that the volume resistance is reduced all the more.

The content of the polyethylene glycol is 0.05 to 0.7 wt%, particularly, 0.1 to 0.6 wt% based on the total weight of the ethylene/alpha-olefin copolymer and the polyethylene glycol.

If the polyethylene glycol is less than 0.05 wt% based on the total weight of the ethylene/alpha-olefin copolymer and the polyethylene glycol, the improving effects of volume resistance may be unsatisfactorily achieved, and if the content is greater than 0.7 wt%, haze may increase to induce the deterioration of optical properties, and there are problems of inadequate use as an encapsulant film.

The composition for an encapsulant film of the present invention may further include one or more selected from the group consisting of a crosslinking agent, a crosslinking auxiliary agent, a silane coupling agent, an unsaturated silane compound, an amino silane compound, a light stabilizer, a UV absorbent and a thermal stabilizer.

The crosslinking agent is a radical initiator in the preparation step of a silane modified resin composition, and may play the role of initiating graft reaction of an unsaturated silane composition onto a resin composition. In addition, by forming a crosslinking bond in the silane modified resin composition, or between the silane modified resin composition and an unmodified resin composition during a lamination step for manufacturing an optoelectronic device, the heat resistant durability of a final product, for example, an encapsulant sheet may be improved.

The crosslinking agent may use various crosslinking agents well-known in this technical field only if it is a crosslinking compound capable of initiating the radical polymerization of a vinyl group or forming a crosslinking bond, for example, one or two or more selected from the group consisting of organic peroxides, hydroxyl peroxides and azo compounds.

Particularly, one or more selected from the group consisting of dialkyl peroxides such as t-butylcumylperoxide, di-t-butyl peroxide, di-cumyl peroxide, 2,5-dimethyl-2,5-di(t-butylperoxy)hexane, and 2,5-dimethyl-2,5-di(t-butylperoxy)-3-hexyne; hydroperoxides such as cumene hydroperoxide, diisopropyl benzene hydroperoxide, 2,5-dimethyl-2,5-di(hydroperoxy)hexane, and t-butyl hydroperoxide; diacyl peroxides such as bis-3,5,5-trimethylhexanoyl peroxide, octanoyl peroxide, benzoyl peroxide, o-methylbenzoyl peroxide, and 2,4-dichlorobenzoyl peroxide; peroxy esters such as t-butylperoxy isobutyrate, t-butylperoxy acetate, t-butylperoxy-2-ethylhexylcarbonate (TBEC), t-butylperoxy-2-ethylhexanoate, t-butylperoxy pyvalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, and 2,5-dimethyl-2,5-di(benzoylperoxy)-3-hexyne; ketone peroxides such as methyl ethyl ketone peroxide and cyclohexanone peroxide, lauryl peroxide, and azo compounds such as azobisisobutyronitrile and azobis(2,4-dimethylvaleronitrile), may be used, without limitation.

The organic peroxide may be an organic peroxide having a one-hour half-life temperature of 120 to 135°C, for example, 120 to 130°C, 120 to 125°C, preferably, 121°C. The "one-hour half-life temperature" means a temperature at which the half-life of the crosslinking agent becomes one hour. According to the one-hour half-life temperature, the temperature at which radical initiation reaction is efficiently performed may become different. Therefore, in case of using the organic peroxide having the one-hour half-life temperature in the above-described range, radical initiation reaction, that is, crosslinking reaction in a lamination process temperature for manufacturing an optoelectronic device may be effectively performed.

The crosslinking agent may be included in 0.01 parts by weight to 1 part by weight, for example, 0.05 to 0.55, 0.1 to 0.5, or 0.15 to 0.45 parts by weight based on 100 parts by weight of the composition for an encapsulant film. If the crosslinking agent is included in less than 0.01 parts by weight, the improving effects of heat resistant properties may be insignificant, and if the amount is greater than 1 part by weight, the moldability of an encapsulant sheet may be degraded, and the problems of generating process limitation or influencing the physical properties of the encapsulant may arise.

A crosslinking auxiliary agent may be included in addition to the crosslinking agent. By including the crosslinking auxiliary agent in a resin composition, the degree of crosslinking of the resin composition by the crosslinking agent may be increased, and accordingly, the heat resistant durability of a final product, for example, an encapsulant sheet may be improved even further.

The crosslinking auxiliary agent may use various crosslinking auxiliary agents well-known in this technical field, and may use a compound containing at least one unsaturated group, for example, an allyl group or a (meth)acryloxy group as the crosslinking auxiliary agent.

The compound containing an allyl group may be, for example, polyallyl compounds such as triallyl isocyanurate (TAIC), triallyl cyanurate, diallyl phthalate, diallyl fumarate and diallyl maleate, and the compound containing a (meth)acryloxy group may be, for example, poly(meth)acryloxy compounds such as ethylene glycol diacrylate, ethylene glycol dimethacrylate, and trimethylolpropane trimethacrylate, without limitation.

The crosslinking auxiliary agent may be included in 0.01 to 0.5 parts by weight, for example, 0.01 to 0.3, 0.015 to 0.2, or 0.016 to 0.16 parts by weight based on 100 parts by weight of the composition for an encapsulant film. If the crosslinking auxiliary agent is included in less than 0.01 parts by weight, improving effects of heat resistant properties may be insignificant, and if the amount included is greater than 0.5 parts by weight, there may be problems of influencing the physical properties of a final product, for example, an encapsulant sheet, and the production cost may increase.

The silane coupling agent may use, for example, one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane (MEMO), without limitation.

The silane coupling agent may be included in 0.1 to 0.4 parts by weight based on 100 parts by weight of the composition for an encapsulant film. If the amount used of the silane coupling agent is less than 0.3, adhesiveness with glass during manufacturing a solar cell module may be poor, water penetration may become easy, and the long-term performance of the module could not be guaranteed. If the amount used is more than 1 part by weight, the silane coupling agent may act as a factor of increasing Y.I, undesirably.

In addition, the composition for an encapsulant film may additionally include an unsaturated silane compound, and an amino silane compound.

The unsaturated silane compound may be grafted into a main chain including the polymerization unit of the monomer of the copolymer of the present invention in the presence of a radical initiator, etc., and included in a polymerized type in a silane modified resin composition or an amino silane modified resin composition.

The unsaturated silane compound may be vinyltrimethoxy silane, vinyltriethoxy silane, vinyltripropoxy silane, vinyltriisopropoxy silane, vinyltributoxy silane, vinyltripentoxy silane, vinyltriphenoxy silane, or vinyltriacetoxy silane, and in an embodiment, vinyltrimethoxy silane or vinyltriethoxy silane may be used among them, without limitation.

In addition, the amino silane compound may act as a catalyst for promoting hydrolysis reaction for converting an unsaturated silane compound grafted in the main chain of the copolymer, for example, a reactive functional group such as the alkoxy group of vinyltriethoxy silane into a hydroxyl group in the grafting modification step of the ethylene/alpha-olefin copolymer, to improve the adhesive strength of upper and lower glass substrates or with a back sheet composed of a fluorine resin, etc. At the same time, the amino silane compound may be directly involved as a reactant in copolymerization reaction and may provide an amino modified resin composition with a moiety having an amine functional group.

The amino silane compound is a silane compound including an amine group and is not specifically limited as long as it is a primary amine or a secondary amine. For example, the amino silane compound may use aminotrialkoxysilane, aminodialkoxysilane, etc., and examples may include one or more selected from the group consisting of 3-aminopropyltrimethoxysilane (APTMS), 3-aminopropyltriethoxysilane (APTES), bis[(3-triethoxysilyl)propyl]amine, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine (DAS), aminoethylaminopropyltriethoxysilane, aminoethylaminopropylmethyldimethoxysilane, aminoethylaminopropylmethyldiethoxysilane, aminoethylaminomethyltriethoxysilane, aminoethylaminomethylmethyldiethoxysilane, diethylenetriaminopropyltrimethoxysilane, diethylenetriaminopropyltriethoxysilane, diethylenetriaminopropylmethyldimethoxysilane, diethyleneaminomethylmethyldiethoxysilane, (N-phenylamino)methyltrimethoxysilane, (N-phenylamino)methyltriethoxysilane, (N-phenylamino)methylmethyldimethoxysilane, (N-phenylamino)methylmethyldiethoxysilane, 3-(N-phenylamino)propyltrimethoxysilane, 3-(N-phenylamino)propyltriethoxysilane, 3-(N-phenylamino)propylmethyldimethoxysilane, 3-(N-phenylamino)propylmethyldiethoxysilane, and N-(N-butyl)-3-aminopropyltrimethoxysilane. The amino silane compound may be used alone or as a mixture type.

The amounts of the unsaturated silane compound and/or the amino silane compound are not specifically limited.

In addition, the composition for an encapsulant film may further include one or more additives selected from a light stabilizer, a UV absorbent, and a thermal stabilizer, as necessary.

The light stabilizer may capture the active species of the photothermal initiation of a resin to prevent photooxidation according to the use applied of the composition. The type of the light stabilizer used is not specifically limited, and for example, known compounds such as a hindered amine-based compound and a hindered piperidine-based compound may be used.

The UV absorbent absorbs ultraviolet rays from the sunlight, etc. and transforms into harmless thermal energy in a molecule, and may play the role of preventing the excitation of the active species of photothermal initiation in the resin composition. Particular types of the UV absorbent used are not specifically limited, and for example, one or a mixture of two or more of benzophenone-based, benzotriazole-based, acrylnitrile-based, metal complex-based, hindered amine-based, inorganic including ultrafine particulate titanium oxide and ultrafine particulate zinc oxide UV absorbents, etc. may be used.

In addition, the thermal stabilizer may include a phosphor-based thermal stabilizer such as tris(2,4-di-tert-butylphenyl)phosphite, phosphorous acid, bis[2,4-bis(1,1-dimethylethyl)-6-methylphenyl]ethylester, tetrakis(2,4-di-tert-butylphenyl)[1,1-biphenyl]-4,4'-diylbisphosphonate and bis(2,4-di-tert-butylphenyl)pentaerythritol diphosphite; and a lactone-based thermal stabilizer such as the reaction product of 8-hydroxy-5,7-di-tert-butyl-furan-2-on and o-xylene, and one or two or more of them may be used.

The amounts of the light stabilizer, UV absorbent, and thermal stabilizer are not specifically limited. That is, the amounts of the additives may be suitably selected considering the use of the resin composition, the shape or density of the additives, etc. Generally, the amounts may be suitably controlled in a range of 0.01 to 5 parts by weight based on 100 parts by weight of the total solid content of the composition for an encapsulant film.

In addition, the composition for an encapsulant film of the present invention may further include various additives known in this art according to the use applied of a resin composition, in addition to the above-described components.

In addition, the composition for an encapsulant film may be utilized in various molded articles by molding by injection, extrusion, etc. Particularly, the composition may be used in various optoelectronic devices, for example, as an encapsulant for the encapsulation of a device in a solar cell, and may be used as an industrial material applied in a lamination process with heating, etc., without limitation.

### <Encapsulant film>

In addition, the present invention provides an encapsulant film including the composition for an encapsulant film.

The encapsulant film of the present invention may be manufactured by molding the composition for an encapsulant film into a film or sheet shape. The molding method is not specifically limited, for example, a sheet or a film may be formed by a common process such as a T die process and extrusion. For example, the manufacture of the encapsulant film may be performed by an in situ process using an apparatus in which the preparation of a modified resin composition using the composition for an encapsulant film and a process for forming a film or a sheet are connected.

The thickness of the encapsulant film may be controlled to about 10 to 2,000 µm, or about 100 to 1,250 um considering the supporting efficiency and breaking possibility of a device in an optoelectronic device, the reduction of the weight or workability of the device, and may be changed according to the particular use thereof.

### <Solar cell module>

In addition, the present invention provides a solar cell module including the encapsulant film. In the present invention, the solar cell module may have a configuration in which the gaps between the solar cells disposed in series or in parallel are filled with the encapsulant film of the present invention, a glass surface is disposed on a side where the sunlight strikes, and a backside is protected by a back sheet, but is not limited thereto. Various types and shapes of the solar cell modules manufactured by including the encapsulant film in this technical field may be applied in the present invention.

The glass surface may use tempered glass for protecting the solar cells from external impact and preventing breaking, and may use low iron tempered glass having the low iron content to prevent the reflection of the sunlight and to increase the transmittance of the sunlight, without limitation.

The back sheet is a climate-resistant film protecting the backside of the solar cell module from exterior, for example, a fluorine-based resin sheet, a metal plate or metal film such as aluminum, a cyclic olefin-based resin sheet, a polycarbonate-based resin sheet, a poly(meth)acryl-based resin sheet, a polyamide-based resin sheet, a polyester-based resin sheet, a laminated composite sheet of a climate-resistant film and a barrier film, etc., without limitation.

Besides, the solar cell module of the present invention may be manufactured by any methods well-known in this technical field only if including the encapsulant film, without limitation.

The solar cell module of the present invention is manufactured using an encapsulant film having excellent volume resistance, and the leakage of current outside through the movement of electrons in the solar cell module through the encapsulant film may be prevented. Accordingly, potential induced degradation phenomenon (PID) by which insulation is degraded, leakage current is generated, and the output of the module is rapidly degraded, may be largely restrained.

### Examples

Hereinafter, the present invention will be explained in more detail referring to embodiments. However, the embodiments are provided only for illustration, and the scope of the present invention is not limited thereto.

### [Preparation of transition metal compound]

### Preparation Example 1

### (1) Preparation of ligand compound

### <Synthesis of N-tert-butyl-1-(1,2-dimethyl-3H-benzo[b]cyclopenta[d]thiophen-3-yl)-1,1-dimethylsilanamine>

To a 100 ml schlenk flask, 4.65 g (15.88 mmol) of chloro(1,2-dimethyl-6,7-dihydro-3H-benzo[b]cyclopenta[d]thiophene-3-yl)dimethylsilane was weighed and added, and 80 ml of THF was injected thereto. At room temperature, tBuNH₂ (4 eq, 6.68 ml) was injected thereto and reacted at room temperature for 3 days. After finishing the reaction, THF was removed, and the resultant reaction product was filtered with hexane. After drying solvents, 4.50 g (86%) of a yellow liquid was obtained.

¹H-NMR (in CDCl₃, 500 MHz): 7.99 (d, 1H), 7.83 (d, 1H), 7.35 (dd, 1H), 7.24 (dd, 1H), 3.49 (s, 1H), 2.37 (s, 3H), 2.17 (s, 3H), 1.27 (s, 9H), 0.19 (s, 3H), -0.17 (s, 3H).

### (2) Preparation of transition metal compound

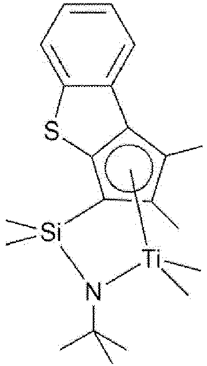

To a 50 ml schlenk flask, the ligand compound (1.06 g, 3.22 mmol/1.0 eq) and 16.0 ml (0.2 M) of MTBE were put and stirred first. n-BuLi (2.64 ml, 6.60 mmol/2.05 eq, 2.5 M in THF) was added thereto at -40°C and reacted at room temperature overnight. After that, MeMgBr (2.68 ml, 8.05 mmol/2.5 eq, 3.0 M in diethyl ether) was slowly added thereto dropwisely at - 40°C, and TiCl₄ (2.68 ml, 3.22 mmol/1.0 eq, 1.0 M in toluene) was put in order, followed by reacting at room temperature overnight. After that, the reaction mixture was passed through celite using hexane for filtration. After dying the solvents, 1.07 g (82%) of a brown solid was obtained.

¹H-NMR (in CDCl₃, 500 MHz): 7.99 (d, 1H), 7.68 (d, 1H), 7.40 (dd, 1H), 7.30 (dd, 1H), 3.22 (s, 1H), 2.67 (s, 3H), 2.05 (s, 3H), 1.54 (s, 9H), 0.58 (s, 3H), 0.57 (s, 3H), 0.40 (s, 3H), -0.45 (s, 3H).

### Preparation Example 2

### (1) Preparation of ligand compound

### <Synthesis of N-tert-butyl-1-(1,2-dimetyl-3H-benzo[b]cyclopenta[d]thiophene-3-yl)-1,1-(methyl)(2-methylphenyl)silaneamine>

### (i) Preparation of chloro-1-(1,2-dimethyl-3H-benzo[b]cyclopenta[d]thiophene-3-yl)-1,1-(methyl)(2-methylphenyl)silane

To a 250 ml schlenk flask, 2.0 g (1.0 eq, 9.985 mmol) of 1,2-dimethyl-3H-benzo[b]cyclopenta[d]thiophene and 50 ml of THF were put, and 4.2 ml (1.05 eq, 10.484 mmol, 2.5 M in hexane) of n-BuLi was added thereto dropwisely at -30°C, followed by stirring at room temperature overnight. A stirred Li-complex THF solution was cannulated into a schlenk flask containing 2.46 g (1.2 eq, 11.982 mmol) of dichloro(o-tolylmethyl)silane and 30 ml of THF at -78°C, followed by stirring at room temperature overnight. After stirring, drying in vacuum was carried out, and extraction with 100 ml of hexane was carried out.

### (ii) Preparation of N-tert-butyl-1-(1,2-dimethyl-3H-benzo[b]cyclopenta[d]thiophene-3-yl)-1,1-(methyl)(2-methylphenyl)silaneamine

After stirring 4.0 g (1.0 eq, 10.0 mmol) of the extracted chloro-1-(1,2-dimethyl-3H-benzo[b]cyclopenta[d]thiophene-3-yl)-1,1-(methyl)(2-methylphenyl)silane was stirred in 10 ml of hexane, and 4.2 ml (4.0 eq, 40.0 mmol) of t-BuNH₂ was injected at room temperature, followed by stirring at room temperature overnight. After stirring, drying in vacuum was carried out, and extraction with 150 ml of hexane was carried out. After drying the solvents, 4.26 g (99%, dr = 1: 0.83) of a sticky liquid was obtained.

¹H-NMR(CDCl₃, 500 MHz): δ 7.95(t, 2H), 7.70(d, 1H), 7.52(d, 1H), 7.47-7.44(m, 2H), 7.24-7.02(m, 9H), 6.97(t, 1H), 3.59(s, 1H), 3.58(s, 1H), 2.50(s, 3H), 2.44(s, 3H), 2.25(s, 3H), 2.16(s, 3H), 2.06(s, 3H), 1.56(s, 3H), 1.02(s, 9H), 0.95(s, 9H), -0.03(s, 3H), -0.11(s, 3H).

### (2)Preparation of transition metal compound

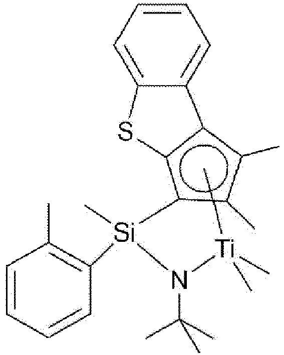

To a 250 ml round flask, the ligand compound (4.26 g, 10.501 mmol) was put in 53 ml (0.2 M) of MTBE and stirred. n-BuLi (8.6 ml, 21.52 mmol, 2.05 eq, 2.5 M in hexane) was added thereto at -40°C and stirred at room temperature overnight.

Then, MeMgBr (8.8 ml, 26.25 mmol, 2.5 eq, 3.0 M in diethyl ether) was slowly added thereto dropwisely at -40°C, and TiCl₄ (10.50 ml, 10.50 mmol) was put in order, followed by stirring at room temperature overnight. After that, the reaction mixture was filtered using hexane. DME (3.3 ml, 31.50 mmol) was added to the filtrate, and the resultant solution was filtered using hexane and concentrated to obtain 3.42 g (68%, dr = 1: 0.68) of a yellow solid.

¹H NMR(CDCl₃, 500 MHz) : δ 7.83 (d, 1H), 7.80 (d, 1H), 7.74(d, 1H), 7.71(d, 1H), 7.68(d, 1H), 7.37(d, 1H), 7.31-6.90(m, 9H), 6.84(t, 1H), 2.54(s, 3H), 2.47(s, 3H), 2.31(s, 3H), 2.20(s, 3H), 1.65(s, 9H), 1.63(s, 9H), 1.34(s, 3H), 1.00(s, 3H), 0.98(s, 3H), 0.81(s, 3H), 0.79(s, 3H), 0.68(s, 3H), 0.14(s, 3H), - 0.03 (s, 3H) .

### [Preparation of ethylene/alpha-olefin copolymer]

While injecting a hexane solvent in 7 kg/h and 1-butene in 0.94 kg/h, a 1.5 L continuous process reactor was pre-heated to 150°C. A triisobutylaluminum compound (0.05 mmol/min), a mixture of the compounds of Preparation Example 1 and Preparation Example 2 in a molar ratio of 1: 1.5, and a dimethylanilinium tetrakis(pentafluorophenyl)borate cocatalyst (1.5 µmol/min) were put in the reactor at the same time. Then, into the reactor, ethylene (0.87 kg/h) and a hydrogen gas (26 cc/min) were injected and copolymerization reaction was continuously carried out while maintaining a pressure of 89 bar and 136.0°C for 60 minutes or more to prepare a copolymer. After drying in a vacuum oven for 12 hours or more, compressing and pelletization process, physical properties were measured.

### [Manufacture of encapsulant film]

### Example 1

To the ethylene/alpha-olefin copolymer prepared above, polyethylene glycol (Sigma Aldrich Co.) having a number average molecular weight of 3,350 g/mol was added, so that the polyethylene glycol was 0.1 wt% based on the total weight of the ethylene/alpha-olefin copolymer and the polyethylene glycol, and an extrusion blended sample was pelletized.

Then, 500 g of the pellet was put in a Planetary Mixer pre-heated to 40°C, and 0.5 phr of a crosslinking auxiliary agent, 0.2 phr of a silane coupling agent, and 1.0 phr of an organic peroxide were respectively added thereto dropwisely, followed by mixing for 1 hour to obtain a composition for an encapsulant film.

After that, under a T-die temperature of 90°C conditions, an encapsulant film with a thickness of 500 ± 100 µm was manufactured.

The number average molecular weight of the polyethylene glycol was confirmed by measuring under the analysis conditions below of gel permeation chromatography (GPC) .
- Column: Ultrahydrogenl 250 + 120
- Solvent: Phosphate buffer solution with pH 6.35
- Flow rate: 0.7 ml/min
- Specimen concentration: 100 mg/ml
- Injection amount: 100 µl
- Column temperature: 35°C
- Detector: Vicsotek TDA 302
- Data processing: OmniSEC 5.0

### Example 2

An encapsulant film was manufactured by the same method as in Example 1 except for using 0.3 wt% of the polyethylene glycol based on the total weight of the ethylene/alpha-olefin copolymer and the polyethylene glycol.

### Example 3

An encapsulant film was manufactured by the same method as in Example 1 except for using 0.5 wt% of the polyethylene glycol based on the total weight of the ethylene/alpha-olefin copolymer and the polyethylene glycol.

### Example 4

An encapsulant film was manufactured by the same method as in Example 1 except for using 0.6 wt% of the polyethylene glycol based on the total weight of the ethylene/alpha-olefin copolymer and the polyethylene glycol.

### Example 5

An encapsulant film was manufactured by the same method as in Example 1 except for using polyethylene glycol having a number average molecular weight of 6,000 g/mol and using 0.5 wt% of the polyethylene glycol based on the total weight of the ethylene/alpha-olefin copolymer and the polyethylene glycol.

### Example 6

An encapsulant film was manufactured by the same method as in Example 1 except for using polyethylene glycol having a number average molecular weight of 8,000 g/mol and using 0.5 wt% of the polyethylene glycol based on the total weight of the ethylene/alpha-olefin copolymer and the polyethylene glycol.

### Example 7

An encapsulant film was manufactured by the same method as in Example 1 except for using polyethylene glycol having a number average molecular weight of 12,000 g/mol and using 0.5 wt% of the polyethylene glycol based on the total weight of the ethylene/alpha-olefin copolymer and the polyethylene glycol.

### Example 8

An encapsulant film was manufactured by the same method as in Example 1 except for using polyethylene glycol having a number average molecular weight of 20,000 g/mol and using 0.5 wt% of the polyethylene glycol based on the total weight of the ethylene/alpha-olefin copolymer and the polyethylene glycol.

### Comparative Example 1

An encapsulant film was manufactured by the same method as in Example 1 except for not mixing the polyethylene glycol.

### Comparative Example 2

An encapsulant film was manufactured by the same method as in Example 1 except for using 0.04 wt% of the polyethylene glycol based on the total weight of the ethylene/alpha-olefin copolymer and the polyethylene glycol.

### Comparative Example 3

An encapsulant film was manufactured by the same method as in Example 1 except for using 0.8 wt% of the polyethylene glycol based on the total weight of the ethylene/alpha-olefin copolymer and the polyethylene glycol.

### Comparative Example 4

An encapsulant film was manufactured by the same method as in Example 1 except for using 1.0 wt% of the polyethylene glycol based on the total weight of the ethylene/alpha-olefin copolymer and the polyethylene glycol.

### Comparative Example 5

An encapsulant film was manufactured by the same method as in Example 1 except for using 3.0 wt% of the polyethylene glycol based on the total weight of the ethylene/alpha-olefin copolymer and the polyethylene glycol.

### Comparative Example 6

An encapsulant film was manufactured by the same method as in Example 1 except for using 5.0 wt% of the polyethylene glycol based on the total weight of the ethylene/alpha-olefin copolymer and the polyethylene glycol.

### Comparative Example 7

An encapsulant film was manufactured by the same method as in Example 1 except for using polyethylene glycol having a number average molecular weight of 400 g/mol and using 0.5 wt% of the polyethylene glycol based on the total weight of the ethylene/alpha-olefin copolymer and the polyethylene glycol.

### Comparative Example 8

An encapsulant film was manufactured by the same method as in Example 1 except for using polyethylene glycol having a number average molecular weight of 100,000 g/mol and using 0.5 wt% of the polyethylene glycol based on the total weight of the ethylene/alpha-olefin copolymer and the polyethylene glycol.

### Comparative Example 9

An encapsulant film was manufactured by the same method as in Example 1 except for using an ethylene/vinyl acetate copolymer instead of the ethylene/alpha-olefin copolymer and not mixing the polyethylene glycol.

### Comparative Example 10

An encapsulant film was manufactured by the same method as in Example 1 except for using an ethylene/vinyl acetate copolymer instead of the ethylene/alpha-olefin copolymer and using 0.5 wt% of the polyethylene glycol based on the total weight of the ethylene/vinyl acetate copolymer and the polyethylene glycol.

### Comparative Example 11

An encapsulant film was manufactured by the same method as in Example 1 except for using an ethylene/vinyl acetate copolymer instead of the ethylene/alpha-olefin copolymer and using 1.0 wt% of the polyethylene glycol based on the total weight of the ethylene/vinyl acetate copolymer and the polyethylene glycol.

**[Table 1]**

| | Copolymer | | PEG |
|---|---|---|---|
| | | Number average molecular weight | Content (wt%) based on total weight of copolymer and PEG |
| Example 1 | Ethylene/alpha-olefin copolymer | 3,350 | 0.1 |
| Example 2 | Ethylene/alpha-olefin copolymer | 3,350 | 0.3 |
| Example 3 | Ethylene/alpha-olefin copolymer | 3,350 | 0.5 |
| Example 4 | Ethylene/alpha-olefin copolymer | 3,350 | 0.6 |
| Example 5 | Ethylene/alpha-olefin copolymer | 6,000 | 0.5 |
| Example 6 | Ethylene/alpha-olefin copolymer | 8,000 | 0.5 |
| Example 7 | Ethylene/alpha-olefin copolymer | 12,000 | 0.5 |
| Example 8 | Ethylene/alpha-olefin copolymer | 20,000 | 0.5 |
| Comparative Example 1 | Ethylene/alpha-olefin copolymer | - | - |
| Comparative Example 2 | Ethylene/alpha-olefin copolymer | 3,350 | 0.04 |
| Comparative Example 3 | Ethylene/alpha-olefin copolymer | 3,350 | 0.8 |
| Comparative Example 4 | Ethylene/alpha-olefin copolymer | 3,350 | 1.0 |
| Comparative Example 5 | Ethylene/alpha-olefin copolymer | 3,350 | 3.0 |
| Comparative Example 6 | Ethylene/alpha-olefin copolymer | 3,350 | 5.0 |
| Comparative Example 7 | Ethylene/alpha-olefin copolymer | 400 | 0.5 |
| Comparative Example 8 | Ethylene/alpha-olefin copolymer | 100,000 | 0.5 |
| Comparative Example 9 | Ethylene/vinyl acetate copolymer | - | - |
| Comparative Example 10 | Ethylene/vinyl acetate copolymer | 3,350 | 0.5 |
| Comparative Example 11 | Ethylene/vinyl acetate copolymer | 3,350 | 1.0 |

### Experimental Example 1

Between two release films (thickness: about 100 µm), each encapsulant film (15 cm × 15 cm) manufactured in the Examples and Comparative Examples was put and crosslinked by laminating in a vacuum laminator at a process temperature of 150°C for a process time of 20 minutes.

### (1) Volume resistance

Measurement was conducted based on ASTM D257 standard. Particularly, a sample was put in a Keithley 8009 test fixture under temperature conditions of 23±1°C and humidity conditions of 50%±3, and measurement was conducted while applying a voltage of 1000 V for 600 seconds using Keithley 6517 electrometer connected.

### (2) Light transmittance

In addition, light transmittance at 550 nm was measured using Shimadzu UV-3600 spectrophotometer (measurement mode: transmittance, wavelength interval: 1 nm, and measurement rate: medium).

**[Table 2]**

| | Volume resistance | Light transmittance |
|---|---|---|
| | (Ω·cm) | % |
| Example 1 | 2.00 × 10¹⁶ | 92.0 |
| Example 2 | 3.50 × 10¹⁶ | 92.0 |
| Example 3 | 6.40 × 10¹⁶ | 92.0 |
| Example 4 | 4.70 × 10¹⁶ | 92.0 |
| Example 5 | 5.20 × 10¹⁶ | 92.0 |
| Example 6 | 5.10 × 10¹⁶ | 92.1 |
| Example 7 | 2.40 × 10¹⁶ | 92.0 |
| Example 8 | 4.50 × 10¹⁶ | 92.0 |
| Comparative Example 1 | 9.50 × 10¹⁵ | 92.1 |
| Comparative Example 2 | 9.80 × 10¹⁵ | 92.0 |
| Comparative Example 3 | 4.70 × 10¹⁶ | 91.9 |
| Comparative Example 4 | 4.50 × 10¹⁶ | 91.8 |
| Comparative Example 5 | 5.70 × 10¹⁶ | 91.3 |
| Comparative Example 6 | 5.10 × 10¹⁶ | 91.0 |
| Comparative Example 7 | 1.20 × 10¹⁶ | 91.5 |
| Comparative Example 8 | 5.40 × 10¹⁵ | 92.0 |
| Comparative Example 9 | 1.29 × 10¹⁴ | 92.3 |
| Comparative Example 10 | 1.11 × 10¹⁴ | 92.1 |
| Comparative Example 11 | 1.32 × 10¹⁴ | 92.0 |

As in Table 2, all the encapsulant films manufactured in Examples 1 to 8 showed excellent volume resistance and light transmittance. On the contrary, in the cases of Comparative Examples 9 to 11, in which not an ethylene/alpha-olefin copolymer but an ethylene/vinyl acetate copolymer was used, volume resistance was markedly low in contrast to the Examples. In addition, it was confirmed that the improving effects of volume resistance was not shown by using the ethylene/vinyl acetate copolymer even though the polyethylene glycol was additionally used.

In addition, even though an ethylene/alpha-olefin copolymer is used, Comparative Example 2 in which the content of the polyethylene glycol was too small, showed low volume resistance.

Meanwhile, it could be found that Comparative Example 7 in which polyethylene glycol having a number average molecular weight of 400 g/mol was used, showed low light transmittance, and Comparative Example 8 in which polyethylene glycol having a number average molecular weight of 100,000 g/mol which is greater than 50,000 g/mol, showed reduced volume resistance all the more.

### Experimental Example 2

According to American Society for Testing and Materials (ASTM) standard D1003, the degree of refraction (%) of light was measured in case of shooting light to 1 T (1 mm) of the encapsulant film. Haze was obtained by measuring the transparency of a specimen according to Td (light refracted)/Tt (light passed through) × 100 (%).

**[Table 3]**

| | Haze |
|---|---|
| | % |
| Example 1 | 3.34 |
| Example 2 | 4.61 |
| Example 3 | 5.82 |
| Example 4 | 5.97 |
| Example 8 | 5.24 |
| Comparative Example 1 | 2.14 |
| Comparative Example 2 | 2.21 |
| Comparative Example 3 | 8.99 |
| Comparative Example 4 | 14.89 |
| Comparative Example 5 | 31.90 |
| Comparative Example 6 | 42.64 |
| Comparative Example 7 | 7.92 |
| Comparative Example 8 | 5.92 |
| Comparative Example 9 | 0.98 |
| Comparative Example 10 | 5.32 |
| Comparative Example 11 | 7.57 |

As in Table 3, it was confirmed that Comparative Examples 3 to 6, in which polyethylene glycol was used in an excessive amount, and Comparative Examples 7 and 8, in which the number average molecular weight deviated from 1,000 to 50,000 g/mol, showed high haze and were inappropriate to use for an encapsulant film. Through Experimental Example 1 and Experimental Example 2, it was confirmed that a composition for an encapsulant film, obtained by mixing an ethylene/alpha-olefin copolymer and polyethylene glycol having a number average molecular weight of 1,000 to 50,000 g/mol and using the polyethylene glycol in 0.05 to 0.7 wt% based on the total weight of the ethylene/alpha-olefin copolymer and the polyethylene glycol, showed excellent volume resistance and light transmittance and low haze, thereby being usefully used for an encapsulant film.

In addition, if one or more among the number average molecular weight and the content of the polyethylene glycol deviated from the ranges defined in the present invention, it could be found that the physical properties required for the composition for an encapsulant film were deteriorated.

## Claims

1. A composition for an encapsulant film, comprising an ethylene/alpha-olefin copolymer and polyethylene glycol, wherein
a number average molecular weight of the polyethylene glycol is 1,000 to 50,000 g/mol, and
a content of the polyethylene glycol is 0.05 to 0.7 wt% based on a total weight of the ethylene/alpha-olefin copolymer and the polyethylene glycol.

2. The composition for an encapsulant film according to claim 1, wherein the number average molecular weight of the polyethylene glycol is 2,000 to 30,000 g/mol.

3. The composition for an encapsulant film according to claim 1, wherein the content of the polyethylene glycol is 0.1 to 0.6 wt% based on the total weight of the ethylene/alpha-olefin copolymer and the polyethylene glycol.

4. The composition for an encapsulant film according to claim 1, further comprising one or more selected from the group consisting of a crosslinking agent, a crosslinking auxiliary agent, a silane coupling agent, an unsaturated silane compound, an amino silane compound, a light stabilizer, a UV absorbent and a thermal stabilizer.

5. The composition for an encapsulant film according to claim 1, wherein the alpha-olefin comprises one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene and 1-eicosene.

6. The composition for an encapsulant film according to claim 1, wherein the alpha-olefin is comprised in greater than 0 to 99 mol% based on the ethylene/alpha olefin copolymer.

7. An encapsulant film comprising the composition for an encapsulant film according to any one of claims 1 to 6.

8. A solar cell module comprising the encapsulant film of claim 7.
